(19) Europäisches Patentamt
European Patent Office
Office européen des brevets

(11) **EP 1 319 987 B1**

(12) **EUROPEAN PATENT SPECIFICATION**

(45) Date of publication and mention
of the grant of the patent:
**28.02.2007 Bulletin 2007/09**

(51) Int Cl.:
*G03F 7/20* (2006.01)

(21) Application number: **02258517.8**

(22) Date of filing: **10.12.2002**

(54) **Lithographic apparatus, device manufacturing method, and computer program therefor**

Lithographischer Apparat, Verfahren zur Herstellung eines Artikels und Computerprogramm dafür

Appareil lithographique, méthode pour la fabrication d'un dispositif, et programme informatique correspondant

(84) Designated Contracting States:
**DE FR GB IT NL**

(30) Priority: **12.12.2001 EP 01310371**

(43) Date of publication of application:
**18.06.2003 Bulletin 2003/25**

(73) Proprietor: **ASML Netherlands B.V.**
**5504 DR Veldhoven (NL)**

(72) Inventor: **Van der Veen, Paul**
**5611 SR Eindhoven (NL)**

(74) Representative: **Leeming, John Gerard**
**J.A. Kemp & Co.,**
**14 South Square,**
**Gray's Inn**
**London WC1R 5JJ (GB)**

(56) References cited:
**EP-A- 0 833 193      EP-A- 1 209 526**
**US-A- 4 460 270      US-A- 4 541 715**
**US-A- 5 171 965      US-B1- 6 268 904**

• **PATENT ABSTRACTS OF JAPAN vol. 10, no. 41 (P-429), 18 February 1986 (1986-02-18) & JP 60 188950 A (CANON INC.), 26 September 1985 (1985-09-26)**
• **PATENT ABSTRACTS OF JAPAN vol. 1999, no. 14, 22 December 1999 (1999-12-22) & JP 11 260288 A (NIKON CORP.), 24 September 1999 (1999-09-24)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).

**Description**

The present invention relates to a lithographic projection apparatus comprising:

- a radiation system for supplying a projection beam of radiation;
- a support structure for supporting patterning means, the patterning means serving to pattern the projection beam according to a desired pattern;
- a substrate table for holding a substrate; and
- a projection system for projecting the patterned beam onto a target portion of the substrate.

The term "patterning means" as here employed should be broadly interpreted as referring to means that can be used to endow an incoming radiation beam with a patterned cross-section, corresponding to a pattern that is to be created in a target portion of the substrate; the term "light valve" can also be used in this context. Generally, the said pattern will correspond to a particular functional layer in a device being created in the target portion, such as an integrated circuit or other device (see below). Examples of such patterning means include:

- A mask. The concept of a mask is well known in lithography, and it includes mask types such as binary, alternating phase-shift, and attenuated phase-shift, as well as various hybrid mask types. Placement of such a mask in the radiation beam causes selective transmission (in the case of a transmissive mask) or reflection (in the case of a reflective mask) of the radiation impinging on the mask, according to the pattern on the mask. In the case of a mask, the support structure will generally be a mask table, which ensures that the mask can be held at a desired position in the incoming radiation beam, and that it can be moved relative to the beam if so desired.
- A programmable mirror array. One example of such a device is a matrix-addressable surface having a viscoelastic control layer and a reflective surface. The basic principle behind such an apparatus is that (for example) addressed areas of the reflective surface reflect incident light as diffracted light, whereas unaddressed areas reflect incident light as undiffracted light. Using an appropriate filter, the said undiffracted light can be filtered out of the reflected beam, leaving only the diffracted light behind; in this manner, the beam becomes patterned according to the addressing pattern of the matrix-addressable surface. An alternative embodiment of a programmable mirror array employs a matrix arrangement of tiny mirrors, each of which can be individually tilted about an axis by applying a suitable localized electric field, or by employing piezoelectric actuation means. Once again, the mirrors are matrix-addressable, such that addressed mirrors will reflect an incoming radiation beam in a different direction to unaddressed mirrors; in this manner, the reflected beam is patterned according to the addressing pattern of the matrix-addressable mirrors. The required matrix addressing can be performed using suitable electronic means. In both of the situations described hereabove, the patterning means can comprise one or more programmable mirror arrays. More information on mirror arrays as here referred to can be gleaned, for example, from United States Patents US 5,296,891 and US 5,523,193, and PCT patent applications WO 98/38597 and WO 98/33096, which are incorporated herein by reference. In the case of a programmable mirror array, the said support structure may be embodied as a frame or table, for example, which may be fixed or movable as required.
- A programmable LCD array. An example of such a construction is given in United States Patent US 5,229,872, which is incorporated herein by reference. As above, the support structure in this case may be embodied as a frame or table, for example, which may be fixed or movable as required.

For purposes of simplicity, the rest of this text may, at certain locations, specifically direct itself to examples involving a mask and mask table; however, the general principles discussed in such instances should be seen in the broader context of the patterning means as hereabove set forth.

Lithographic projection apparatus can be used, for example, in the manufacture of integrated circuits (ICs). In such a case, the patterning means may generate a circuit pattern corresponding to an individual layer of the IC, and this pattern can be imaged onto a target portion (*e.g.* comprising one or more dies) on a substrate (silicon wafer) that has been coated with a layer of radiation-sensitive material (resist). In general, a single wafer will contain a whole network of adjacent target portions that are successively irradiated via the projection system, one at a time. In current apparatus, employing patterning by a mask on a mask table, a distinction can be made between two different types of machine. In one type of lithographic projection apparatus, each target portion is irradiated by exposing the entire mask pattern onto the target portion in one go; such an apparatus is commonly referred to as a wafer stepper. In an alternative apparatus - commonly referred to as a step-and-scan apparatus - each target portion is irradiated by progressively scanning the mask pattern under the projection beam in a given reference direction (the "scanning" direction) while synchronously scanning the substrate table parallel or anti-parallel to this direction; since, in general, the projection system will have a magnification factor M (generally < 1), the speed V at which the substrate table is scanned will be a factor M times that at which the mask table is scanned. More information with regard to lithographic devices as here described can be gleaned, for example, from US 6,046,792, incorporated herein by reference.

In a manufacturing process using a lithographic projection apparatus, a pattern (*e.g.* in a mask) is imaged onto a substrate that is at least partially covered by a layer of radiation-sensitive material (resist). Prior to this imaging step, the substrate may undergo various procedures, such as priming, resist coating and a soft bake. After exposure, the substrate may be subjected to other procedures, such as a post-exposure bake (PEB), development, a hard bake and measurement/inspection of the imaged features. This array of procedures is used as a basis to pattern an individual layer of a device, *e.g.* an IC. Such a patterned layer may then undergo various processes such as etching, ion-implantation (doping), metallization, oxidation, chemo-mechanical polishing, etc., all intended to finish off an individual layer. If several layers are required, then the whole procedure, or a variant thereof, will have to be repeated for each new layer. Eventually, an array of devices will be present on the substrate (wafer). These devices are then separated from one another by a technique such as dicing or sawing, whence the individual devices can be mounted on a carrier, connected to pins, etc. Further information regarding such processes can be obtained, for example, from the book "Microchip Fabrication: A Practical Guide to Semiconductor Processing", Third Edition, by Peter van Zant, McGraw Hill Publishing Co., 1997, ISBN 0-07-067250-4, incorporated herein by reference.

For the sake of simplicity, the projection system may hereinafter be referred to as the "lens"; however, this term should be broadly interpreted as encompassing various types of projection system, including refractive optics, reflective optics, and catadioptric systems, for example. The radiation system may also include components operating according to any of these design types for directing, shaping or controlling the projection beam of radiation, and such components may also be referred to below, collectively or singularly, as a "lens". Further, the lithographic apparatus may be of a type having two or more substrate tables (and/or two or more mask tables). In such "multiple stage" devices the additional tables may be used in parallel, or preparatory steps may be carried out on one or more tables while one or more other tables are being used for exposures. Dual stage lithographic apparatus are described, for example, in US 5,969,441 and WO 98/40791, incorporated herein by reference.

In order to image smaller features than is possible with systems presently available commercially, using 193nm exposure radiation, it is proposed to use 157nm radiation instead. However, 157nm radiation is strongly absorbed by water ($H_2O$) and hydrocarbons so that contamination of a lithographic apparatus using 157nm radiation causes a significant loss of energy from the projection beam. Whilst a uniform loss of energy from the beam can be compensated for by increasing the output of the radiation source (within limits) or by increasing exposure times (albeit at the cost of throughput), uneven contamination of the mask can lead to unacceptable dose variation across an exposure. Dose errors can lead to variation in the sizes of printed features. It is known to keep masks in clean conditions and to clean them, *e.g.* using UV lamps, prior to use but nevertheless sufficient residual contamination can remain to adversely affect exposures, and contamination can build up during use of a mask for a series of exposures.

US 4,451,715 discloses an apparatus for detecting contaminants deposited on a reticle in a lithographic projection apparatus using a laser spot scanner. In the event a contaminant is detected, the reticle is cleaned.

It should be noted that the provision of a pellicle does not alleviate this problem - although contaminants on a pellicle are out of focus and do not print, there is still a localized loss of intensity.

Also, known arrangements, such as disclosed in EP 0 833 193 A2 where an energy sensor is calibrated by measurements taken at wafer level, do not take account of mask contamination. The calibration is performed off-line, without a mask in place or with a reference mark, not a production mask, in place.

US 5,171,965 measures the projection beam intensity using an energy sensor to which radiation is directed from before the mask.

It is an object of the present invention to avoid or reduce dose variations caused by contamination of the mask by absorbent compounds, dust, or other particulates, etc..

According to the present invention, there is provided a lithographic projection apparatus comprising:

- a radiation system for providing a projection beam of radiation;
- a support structure for supporting patterning means, the patterning means serving to endow the projection beam with a patterned cross-section corresponding to a desired pattern that is to be created in a target portion, the patterning means comprising a mask or a programmable mirror array;
- a substrate table for holding a substrate;
- a projection system for projecting the patterned beam onto a target portion of the substrate,

characterized by:

prediction means for predicting, on the basis of the history of the patterning means, the undesired intensity loss in the patterned beam due to surface contamination of said patterning means; and
compensation means responsive to the predicted intensity loss for compensating for the predicted intensity loss.

The present invention, by predicting and compensating for intensity losses due to surface contamination of the patterning means can improve delivery of the correct dose at substrate level and improve uniformity. Preferably, the intensity losses are predicted as a function of position on the patterning means and time. At the time of an exposure, the instantaneous intensity loss is predicted and the compensation effected accordingly. This can further improve the dose accuracy and uniformity.

The prediction of intensity loss can be based on empirical data, *e.g.* derived from test exposures, characterizing temporally and spatially the contamination patterns of the apparatus or other apparatus of like type. Where the patterning means is a mask, the empirical data may also characterize the contamination pattern of any associated mask handling devices, such as a mask library, and the operational effectiveness of any associated cleaning device(s).

The intensity loss may be due to a decrease in transmissivity in a transmissive mask or a decrease in reflectivity in a reflective mask.

The present invention can also predict and correct irradiation induced transmission/reflection losses in the mask, instead of or in addition to intensity losses due to surface contamination. Such irradiation induced transmission/ reflection losses occur because of the physical properties of the material from which the mask is made any may include transient effects and long-term effects, including permanent degradation of the mask, which are predicted on the basis of the history of use of the mask. The irradiation induced transmission/reflection losses can be predicted on the basis of theoretical calculations or empirical data derived by experiment with samples of the material from which the mask is made.

According to a further aspect of the invention there is provided a device manufacturing method comprising the steps of:

- providing a substrate that is at least partially covered by a layer of radiation-sensitive material;
- providing a projection beam of radiation using a radiation system;
- using patterning means to endow the projection beam with a pattern in its cross-section corresponding to a desired pattern to be created in a substrate, the patterning means comprising a mask or a programmable mirror array;
- projecting the patterned beam of radiation onto a target portion of the layer of radiation-sensitive material,

characterized by the further steps of:

predicting, on the basis of the history of said patterning means, the undesired intensity loss in the patterned beam due to surface contamination of said patterning means; and
compensating for the predicted intensity loss.

The present invention further provides a computer program for operating a lithographic projection apparatus employing a patterning means to endow a projection beam with a pattern in its cross-section corresponding to a desired pattern to be created in a substrate, the patterning means comprising a mask or a programmable mirror array, said computer program comprising code means for instructing a lithographic projection apparatus employing a patterning means to:

predict, on the basis of the history of said patterning means, the undesired intensity loss in the patterned beam due to surface contamination of said patterning means; and
controlling said lithographic projection apparatus to compensate for the predicted intensity loss.

Such a computer program can be provided as an upgrade to existing lithographic apparatus.

Although specific reference may be made in this text to the use of the apparatus according to the invention in the manufacture of ICs, it should be explicitly understood that such an apparatus has many other possible applications. For example, it may be employed in the manufacture of integrated optical systems, guidance and detection patterns for magnetic domain memories, liquid-crystal display panels, thin-film magnetic heads, etc. The skilled artisan will appreciate that, in the context of such alternative applications, any use of the terms "reticle", "wafer" or "die" in this text should be considered as being replaced by the more general terms "mask", "substrate" and "target portion", respectively.

In the present document, the terms "radiation" and "beam" are used to encompass all types of electromagnetic radiation, including ultraviolet radiation (*e.g.* with a wavelength of 365, 248, 193, 157 or 126 nm) and EUV (extreme ultra-violet radiation, *e.g.* having a wavelength in the range 5-20 nm).

Embodiments of the invention will now be described, by way of example only, with reference to the accompanying schematic drawings in which:

Figure 1 depicts a lithographic projection apparatus according to an embodiment of the invention;
Figure 2 depicts components of a control system in the embodiment of the invention;

Figures 3 and 4 are graphs showing the effect of contamination on the transmission of test reticles.

In the Figures, corresponding reference symbols indicate corresponding parts.

Embodiment 1

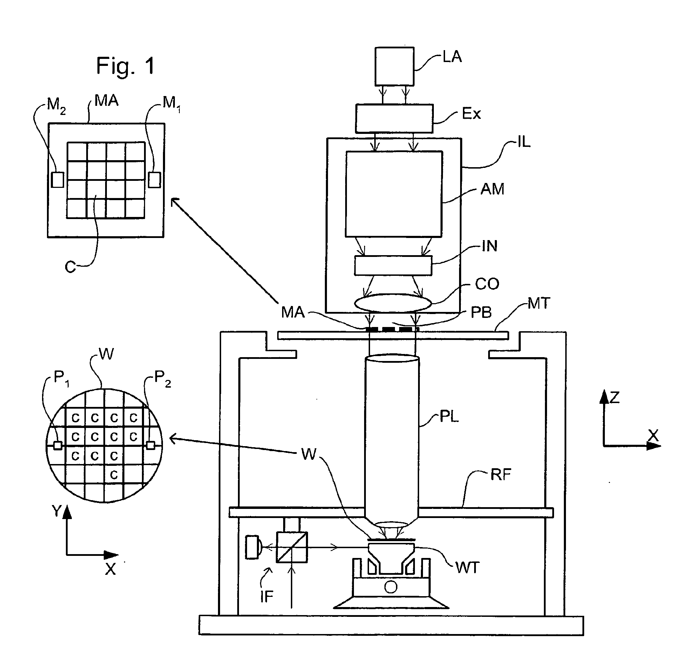

Figure 1 schematically depicts a lithographic projection apparatus according to a particular embodiment of the invention. The apparatus comprises:

· a radiation system Ex, IL, for supplying a projection beam PB of radiation (*e.g.* UV radiation of wavelength 157nm), which in this particular case also comprises a radiation source LA;
· a first object table (mask table) MT provided with a mask holder for holding a mask MA (*e.g.* a reticle), and connected to first positioning means for accurately positioning the mask with respect to item PL;
· a second object table (substrate table) WT provided with a substrate holder for holding a substrate W (*e.g.* a resist-coated silicon wafer), and connected to second positioning means for accurately positioning the substrate with respect to item PL;
· a projection system ("lens") PL (*e.g.* a lens group) for imaging an irradiated portion of the mask MA onto a target portion C (*e.g.* comprising one or more dies) of the substrate W.

As here depicted, the apparatus is of a transmissive type (*i.e.* has a transmissive mask). However, in general, it may also be of a reflective type, for example (with a reflective mask). Alternatively, the apparatus may employ another kind of patterning means, such as a programmable mirror array of a type as referred to above.

The source LA *(e.g.* an excimer laser) produces a beam of radiation. This beam is fed into an illumination system (illuminator) IL, either directly or after having traversed conditioning means, such as a beam expander Ex, for example. The illuminator IL may comprise adjusting means AM for setting the outer and/or inner radial extent (commonly referred to as σ-outer and σ-inner, respectively) of the intensity distribution in the beam. In addition, it will generally comprise various other components, such as an integrator IN and a condenser CO. In this way, the beam PB impinging on the mask MA has a desired uniformity and intensity distribution in its cross-section.

It should be noted with regard to Figure 1 that the source LA may be within the housing of the lithographic projection apparatus (as is often the case when the source LA is a mercury lamp, for example), but that it may also be remote from the lithographic projection apparatus, the radiation beam which it produces being led into the apparatus (*e.g.* with the aid of suitable directing mirrors); this latter scenario is often the case when the source LA is an excimer laser. The current invention and Claims encompass both of these scenarios.

The beam PB subsequently intercepts the mask MA, which is held on a mask table MT. Having traversed the mask MA, the beam PB passes through the lens PL, which focuses the beam PB onto a target portion C of the substrate W. With the aid of the second positioning means (and interferometric measuring means IF), the substrate table WT can be moved accurately, *e.g.* so as to position different target portions C in the path of the beam PB. Similarly, the first positioning means can be used to accurately position the mask MA with respect to the path of the beam PB, *e.g.* after mechanical retrieval of the mask MA from a mask library, or during a scan. In general, movement of the object tables MT, WT will be realized with the aid of a long-stroke module (course positioning) and a short-stroke module (fine positioning), which are not explicitly depicted in Figure 1. However, in the case of a wafer stepper (as opposed to a step-and-scan apparatus) the mask table MT may just be connected to a short stroke actuator, or may be fixed.

The depicted apparatus can be used in two different modes:

1. In step mode, the mask table MT is kept essentially stationary, and an entire mask image is projected in one go (*i.e.* a single "flash") onto a target portion C. The substrate table WT is then shifted in the x and/or y directions so that a different target portion C can be irradiated by the beam PB;
2. In scan mode, essentially the same scenario applies, except that a given target portion C is not exposed in a single "flash". Instead, the mask table MT is movable in a given direction (the so-called "scan direction", *e.g.* the y direction) with a speed ν, so that the projection beam PB is caused to scan over a mask image; concurrently, the substrate table WT is simultaneously moved in the same or opposite direction at a speed $V = M\nu$, in which $M$ is the magnification of the lens PL (typically, $M = 1/4$ or $1/5$). In this manner, a relatively large target portion C can be exposed, without having to compromise on resolution.

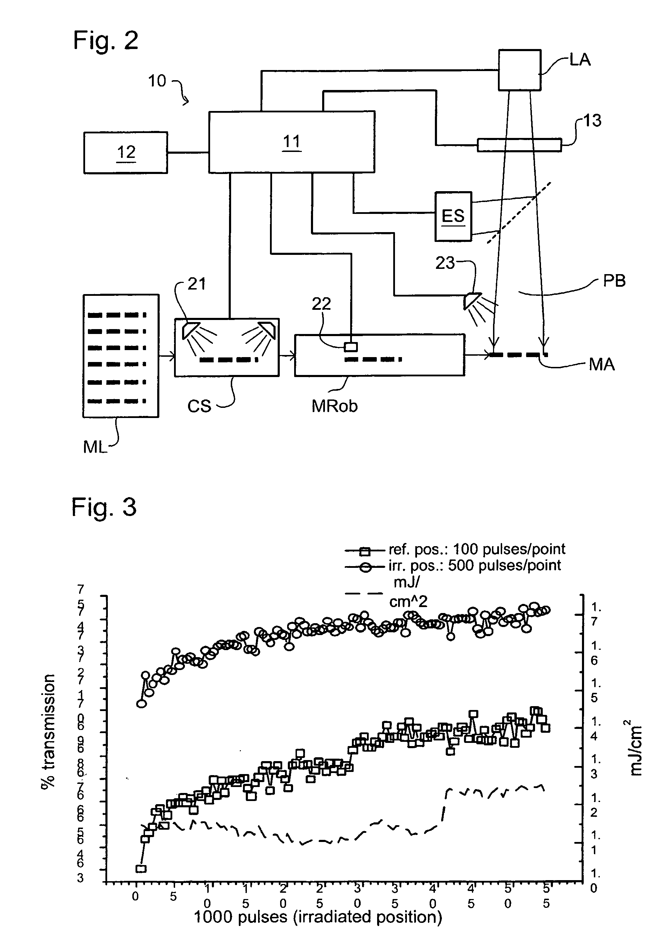

Figure 2 depicts selected components of the lithographic apparatus of Figure 1 relating to the loading of masks into the apparatus and the control of the exposure, including the dose delivered to the substrate. Other parts are omitted for clarity.

Masks to be used in a production run are stored in a mask library ML provided adjacent the lithographic apparatus. Whilst the masks are manufactured, transported and stored under clean conditions, nevertheless contaminants that absorb UV radiation, especially radiation at 157nm, may be present and may cause undesirable decreases in transmission, uniformity and dose control. Such contaminants may include volatile contaminants such as hydrocarbons and water as well as non-volatile contaminants, *e.g.* deriving from packaging and cleaning materials. Additionally, volatile contaminants may be deposited on the mask from fab air in the lithography unit when the masks are loaded into the lithographic apparatus.

To minimize contamination, masks may pass through cleaning station CS before being loaded into the lithography device by mask robot MRob. At the cleaning station CS, the mask is, for example, irradiated by UV lamps 21 to drive off at least some volatile contaminants.

Even after such cleaning, contaminants will remain on the mask and further contaminants may be deposited on the mask during loading into the lithographic apparatus and whilst the mask is held in the lithographic apparatus for a series of exposures. According to the invention, the contamination of the mask is characterized by the resulting mask transmissivity error, MTE, which is a function of space (position on the mask) and time.

For a given mask, cleaning station and/or lithographic apparatus, the MTE function is determined by a compilation of measurement, *e.g.* using a sensor 22 in the mask robot MRob, and/or prediction, *e.g.* based on calibration measurements carried out in advance. The MTE function may also take account of the cleaning effect of the projection beam radiation during an exposure. This is described further below.

In an embodiment of the invention, the MTE function for a mask being loaded into the lithographic apparatus is calculated by control means 11 on the basis of information as to the cleaning process carried out by cleaning station CS, data from sensor 22 and empirical data stored in storage means 12 and relating to the specific set up and characteristics of the lithographic and mask handling arrangements. The empirical data may be derived from experiments carried out on the lithographic apparatus in question or on other lithographic apparatus of the same type or even, to the extent that the relevant effects are comparable, on different types of apparatus.

The history of the stage of the mask, *e.g.* the length of time the mask has been stored and under what conditions, can also be taken into account. Further, if the mask has a pellicle, the type of glue used to attach the pellicle can be taken into account. If a lamp 23 is provided for in-situ mask cleaning, the operation of this may also be taken into account.

Given the MTE as a function of space and time, the transmission error over the area of the mask at the time of a specific exposure can be calculated and appropriate corrections applied to improve uniformity and deliver the correct dosage to the substrate. The correction may involve control of: the radiation source LA output; the exposure duration (scanning speed in a scanner); and/or local dose adjustments. It will be appreciated that any adjustments necessitated by the MTE will be combined with other control schemes dealing with other effects and with feedback control of the radiation source LA output using energy sensor ES which monitors a fraction of the projection beam PB directed aside by, for example, a partial mirror.

In an embodiment of the invention, the MTE at the time of an exposure is calculated by control means 11 and appropriate control signals are provided to radiation source LA and/or, a variable aperture and/or a local dose adjustment device 13. Exposure duration control can also be effected by control signals provided to a shutter (not shown) and to the mask and substrate table positioning systems. Optionally, the predicted MTE may be referred to in determining whether to operate any in-situ cleaning device that may be provided.

The local dose adjustment device may be a device as described in US 6,013,401, the contents of which are hereby incorporated by reference, if the lithography apparatus is of the scanning type. A device such as described in EP-A 0 952 491 may also be used.

To control the dose, it is convenient to compensate for an overall transmission offset by controlling the source intensity, a variable aperture or the exposure duration. Local differences from the offset are then compensated for by the local dose control device 13.

To calculate the transmission loss caused by a contaminant, the following formula can be used:

$$\frac{I}{I_o} = e^{-\phi\sigma} \qquad\qquad (1)$$

where $I$ = transmitted intensity

$I_O$ = incident intensity

$\phi$ = number of absorbed molecules in a monolayer ($cm^{-2}$)

$\sigma$ = molecular absorption cross-section at 157nm ($10^{-8}\ cm^2$).

For small molecules such as $H_2O$ a typical value for the number of absorbed molecules in a monolayer is 1 x

$10^{15}$. For larger molecules, the number of absorbed molecules per surface area depends on the orientation of the absorbed molecules with respect to the surface. In Table 1 below an estimate of transmission losses is presented for two common species. Due to the formation of hydrogen bonds both species will form very stable (hard to remove) monolayer(s) on the surface. The number of monolayers present on the surface is typically between 1 to 4.

| Compound | transmission loss per film (%) | | transmission loss of a mask (%) | |
| --- | --- | --- | --- | --- |
| | 1 monolayer | 3 monolayers | 1 monolayer | 3 monolayers |
| water | 0.25 | 0.7 | 0.5 | 1.4 |
| acetone | 1.3 | 3.8 | 2.6 | 7.5 |

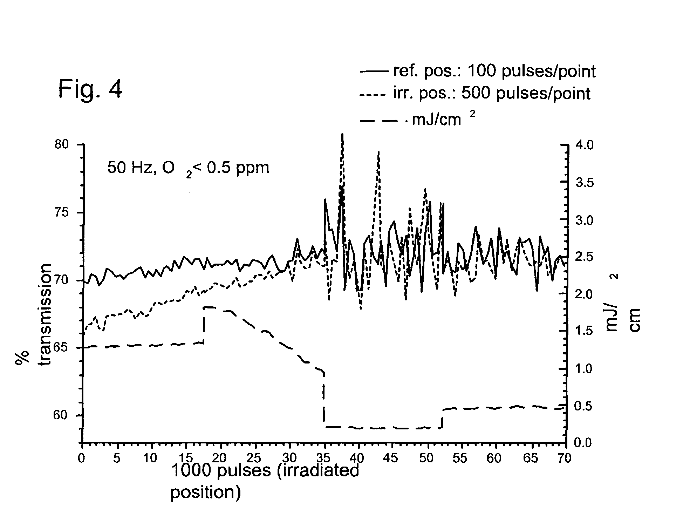

In Figures 3 and 4 the results of 157nm transmission measurements at two points on a quartz reticle substrate are presented. The reticle substrate was a phase 2 quality 157nm reticle quartz from Asahi. It can be seen from Figures 3 and 4 that the transmission of the mask varies with time and position. These variations are compensated for in the present invention.

Whilst specific embodiments of the invention have been described above, it will be appreciated that the invention may be practiced otherwise than as described. The description is not intended to limit the invention.

**Claims**

1. A lithographic projection apparatus comprising:

   - a radiation system (IL) for providing a projection beam of radiation;
   - a support structure (MT) for supporting patterning means (MA), the patterning means serving to endow the projection beam with a patterned cross-section corresponding to a desired pattern that is to be created in a target portion, the patterning means comprising a mask or a programmable mirror array;
   - a substrate table (WT) for holding a substrate (W);
   - a projection system (PL) for projecting the patterned beam onto a target portion of the substrate,

   **characterized by**:

   prediction means (11) for predicting, on the basis of the history of the patterning means, the undesired intensity loss in the patterned beam due to surface contamination of said patterning means; and
   compensation means (13) responsive to the predicted intensity loss for compensating for the predicted intensity loss.

2. Apparatus according to claim 1 wherein said prediction means (11) predicts the intensity loss on the basis of the length of a period of time during which said patterning means was not used.

3. Apparatus according to claim 1 or 2, wherein said prediction means (11) predicts the intensity loss on the basis of the length of time and/or the number of exposures performed and/or the total energy irradiated to said mask since said patterning means was loaded into said apparatus.

4. Apparatus according to claim 1, 2 or 3 wherein said patterning means is a mask (MA) having a pellicle glued thereto and said prediction means predicts said intensity loss on the basis of the composition of the glue used to glue said pellicle to said mask.

5. Apparatus according to claim 1, 2, 3 or 4, wherein said prediction means (11) predicts said intensity loss at least once per exposure of a target portion (6) and said compensation means effects compensation according to each prediction.

6. Apparatus according to any one of claims 1 to 5 wherein said compensation (11) means comprises control means for adjusting an operating parameter of said apparatus.

7. Apparatus according to claim 6 wherein said operating parameter is selected from the group comprising: the intensity of the projection beam supplied by said radiation system, a variable attenuator provided in the path of the projection beam, and the duration for which the patterned beam is projected onto said target portion.

8. Apparatus according to any one of the preceding claims wherein said prediction means (11) predicts said intensity loss as a function of position on said mask and said compensation means (13) effects a compensation on the exposure dose delivered to the substrate also as a function of position.

9. Apparatus according to any one of the preceding claims wherein said prediction is calculated based on empirically derived data relating to the time and spatial distribution of contamination in said apparatus or in like apparatus.

10. Apparatus according to claim 9 wherein said patterning means is a mask (MA) and said empirically derived data includes data relating to contamination in an associated mask handling apparatus (ML) and the operation of an associated mask cleaning device(s) (CS).

11. Apparatus according to any one of the preceding claims wherein said prediction means (11) predicts the undesired intensity loss due to irradiation induced effects in the patterning means instead of or in addition to the loss caused by surface contamination.

12. A device manufacturing method comprising the steps of:

   - providing a substrate that is at least partially covered by a layer of radiation-sensitive material;
   - providing a projection beam of radiation using a radiation system;
   - using patterning means to endow the projection beam with a pattern in its cross-section corresponding to a desired pattern to be created in a substrate, the patterning means comprising a mask or a programmable mirror array;
   - projecting the patterned beam of radiation onto a target portion of the layer of radiation-sensitive material,

   **characterized by** the further steps of:

   predicting, on the basis of the history of said patterning means, the undesired intensity loss in the patterned beam due to surface contamination of said patterning means; and
   compensating for the predicted intensity loss.

13. A computer program for operating a lithographic projection apparatus employing a patterning means to endow a projection beam with a pattern in its cross-section corresponding to a desired pattern to be created in a substrate, the patterning means comprising a mask or a programmable mirror array, said computer program comprising code means for instructing a lithographic projection apparatus employing a patterning means to:

   predict, on the basis of the history of said patterning means, the undesired intensity loss in the patterned beam due to surface contamination of said patterning means; and
   controlling said lithographic projection apparatus to compensate for the predicted intensity loss.

**Patentansprüche**

1. Lithografischer Projektionsapparat, der folgendes aufweist:

   - ein Bestrahlungssystem (IL) zum Bereitstellen eines Projektionsstrahles einer Strahlung;
   - eine Tragstruktur (MT) zum Tragen einer Musterungsvorrichtung (MA), wobei die Musterungsvorrichtung dazu dient, dem Projektionsstrahl einen gemusterten Querschnitt zu geben, welcher einem gewünschten Muster entspricht, das in einem Zielbereich zu erzeugen ist, wobei die Musterungsvorrichtung eine Maske oder eine programmierbare Spiegelanordnung aufweist;
   - einen Substrattisch (WT) zum Halten eines Substrats (W);
   - ein Projektionssystem (TL) zum Projizieren des gemusterten Strahls auf einen Zielbereich des Substrats,

   **gekennzeichnet durch**

   eine Vorhersagevorrichtung (11) zum Vorhersagen, und zwar auf Basis der Vergangenheit der Musterungsvorrichtung, des unerwünschten Intensitätsverlustes in dem gemusterten Strahl aufgrund von Oberflächenkontamination der Musterungsvorrichtung; und
eine Kompensationsvorrichtung (3), zum Kompensieren des vorhergesagten Intensitätsverlustes in Reaktion auf den vorhergesagten Intensitätsverlust.

2. Apparat nach Anspruch 1, wobei die Vorhersagevorrichtung (11) den Intensitätsverlust auf Basis der Länge einer Zeitspanne vorhersagt, während der die Musterungsvorrichtung nicht verwendet wurde.

3. Apparat nach Anspruch 1 oder 2, wobei die Vorhersagevorrichtung (11) den Intensitätsverlust auf Basis der Zeitlänge und/oder der Anzahl durchgeführter Belichtungen und/oder der Gesamtenergie vorhersagt, die der Maske zugestrahlt wurde, seitdem der Apparat mit der Musterungsvorrichtung bestückt wurde.

4. Apparat nach Anspruch 1, 2 oder 3, wobei die Musterungsvorrichtung eine Maske (MA) ist, an die eine Membran angeklebt ist, und wobei die Vorhersagevorrichtung den Intensitätsverlust auf Basis der Zusammensetzung des Klebers vorhersagt, der verwendet wird, um die Membran an die Maske anzukleben.

5. Apparat nach Anspruch 1, 2, 3 oder 4, wobei die Vorhersagevorrichtung (11) den Intensitätsverlust mindestens einmal pro Belichtung eines Zielbereichs (6) vorhersagt und wobei die Kompensationsvorrichtung die Kompensation gemäß jeder Vorhersage bewirkt.

6. Apparat nach einem der Ansprüche 1 bis 5, wobei die Kompensationsvorrichtung (11) eine Steuerungsvorrichtung zum Einstellen eines Betriebsparameters des Apparates aufweist.

7. Apparat nach Anspruch 6, wobei der Betriebsparameter aus der Gruppe ausgewählt wird, welche aufweist: die Intensität des Projektionsstrahles, der von dem Strahlungssystem zur Verfügung gestellt wird, ein im Weg des Projektionsstrahls vorgesehener variabler Abschwächer, und die Dauer, während welcher der gemusterte Strahl auf den Zielbereich projiziert wird.

8. Apparat nach einem der vorhergehenden Ansprüche, wobei die Vorhersagevorrichtung (11) den Intensitätsverlust als eine Funktion einer Position auf der Maske vorhersagt und wobei die Kompensationsvorrichtung (13) eine Kompensation der Belichtungsdosis, die an das Substrat abgegeben wurde, ebenfalls als eine Funktion einer Position bewirkt.

9. Apparat nach einem der vorhergehenden Ansprüche, wobei die Vorhersage basierend auf empirisch erhaltenen Daten berechnet wird, welche die zeitliche und räumliche Verteilung von Kontaminationen in dem Apparat oder in vergleichbaren Apparaten betreffen.

10. Apparat nach Anspruch 9, wobei die Musterungsvorrichtung eine Maske (MA) ist und die empirisch erhaltenen Daten solche Daten beinhalten, die eine Kontamination in einem zugeordneten Maskenbearbeitungsapparat (ML) und den Betrieb einer oder mehrerer zugeordneter Maskenreinigungseinrichtungen (CS) betreffen.

11. Apparat nach einem der vorhergehenden Ansprüche, wobei die Vorhersagevorrichtung (11) den unerwünschten Intensitätsverlust aufgrund von bestrahlungsinduzierten Effekten in der Musterungsvorrichtung anstelle von oder zusätzlich zu dem durch Oberflächenkontamination verursachten Verlust vorhersagt.

12. Herstellungsverfahren für eine Einrichtung, mit den folgenden Schritten:

- Bereitstellen eines Substrates, das mindestens teilweise mit einer Schicht strahlungssensitiven Materials belegt ist;
- Vorsehen eines Projektionsstrahles einer Strahlung unter Verwendung eines Strahlungssystems;
- Verwenden einer Musterungsvorrichtung, um dem Projektionsstrahl in seinem Querschnitt ein Muster zu geben, welches einem gewünschten Muster entspricht, das in einem Substrat zu erzeugen ist, wobei die Musterungsvorrichtung eine Maske oder eine programmierbare Spiegelanordnung aufweist;
- Projizieren des gemusterten Strahles einer Strahlung auf einen Zielbereich der Schicht des strahlungssensitiven Materials,

**gekennzeichnet durch** die folgenden weiteren Schritte:

Vorhersagen, und zwar auf Basis der Vergangenheit der Musterungsvorrichtung, des unerwünschten Intensitätsverlustes in dem gemusterten Strahl aufgrund von Oberflächenkontamination der Musterungsvorrichtung; und

Kompensieren des vorhergesagten Intensitätsverlustes.

13. Computerprogramm zum Betreiben eines lithografischen Projektionsapparates, welches eine Musterungsvorrichtung einsetzt, um einem Projektionsstrahl in seinem Querschnitt ein Muster zu geben, welches einem gewünschten Muster entspricht, das in einem Substrat zu erzeugen ist, wobei die Musterungsvorrichtung eine Maske oder eine programmierbare Spiegelanordnung aufweist, und wobei das Computerprogramm Programmcodeteile aufweist, um einen lithografischen Projektionsapparat, der eine Musterungsvorrichtung einsetzt, folgendermaßen zu instruieren:

sage den unerwünschten Intensitätsverlust in dem gemusterten Strahl aufgrund von Oberflächenkontamination der Musterungsvorrichtung vorher, und zwar auf Basis der Vergangenheit der Musterungsvorrichtung; und

steuere den lithografischen Projektionsapparat, um den vorhergesagten Intensitätsverlust zu kompensieren.

## Revendications

1. Appareil de projection lithographique comprenant :

- un système de rayonnement (IL) pour délivrer un faisceau de projection de rayonnement ;
- une structure de support (MT) pour supporter des moyens de mise en forme (MA), les moyens de mise en forme servant à doter le faisceau de projection d'une section transversale mise en forme correspondant à un motif voulu qui est à créer dans une partie cible, les moyens de mise en forme comprenant un masque ou un réseau de miroirs programmables ;
- une table de substrat (WT) pour maintenir un substrat (W) ;
- un système de projection (PL) pour projeter le faisceau mis en forme sur une partie cible du substrat,

**caractérisé par :**

des moyens de prédiction (11) pour prédire, sur la base de l'historique des moyens de mise en forme, la perte d'intensité non voulue dans le faisceau mis en forme due à une contamination de surface desdits moyens de mise en forme ; et

des moyens de compensation (13) sensibles à la perte d'intensité prédite pour compenser la perte d'intensité prédite.

2. Appareil selon la revendication 1, dans lequel lesdits moyens de prédiction (11) prédisent la perte d'intensité sur la base de la longueur d'une période de temps pendant laquelle lesdits moyens de mise en forme n'ont pas été utilisés.

3. Appareil selon la revendication 1 ou 2, dans lequel lesdits moyens de prédiction (11) prédisent la perte d'intensité sur la base de la longueur de temps et/ou du nombre d'expositions effectués et/ou de l'énergie totale irradiée sur ledit masque depuis que lesdits moyens de mise en forme ont été chargés dans ledit appareil.

4. Appareil selon la revendication 1, 2 ou 3, dans lequel lesdits moyens de mise en forme sont un masque (MA) ayant une pellicule collée dessus et lesdits moyens de prédiction prédisent ladite perte d'intensité sur la base de la composition de la colle utilisée pour coller ladite pellicule audit masque.

5. Appareil selon la revendication 1, 2, 3 ou 4, dans lequel lesdits moyens de prédiction (11) prédisent ladite perte d'intensité au moins une fois par exposition d'une partie cible (6) et lesdits moyens de compensation effectuent une compensation conformément à chaque prédiction.

6. Appareil selon l'une quelconque des revendications 1 à 5, dans lequel lesdits moyens de compensation (11) comportent des moyens de commande pour ajuster un paramètre de fonctionnement dudit appareil.

7. Appareil selon la revendication 6, dans lequel ledit paramètre de fonctionnement est sélectionné parmi le groupe comportant: l'intensité du faisceau de projection délivré par ledit système de rayonnement, un atténuateur variable agencé dans le trajet du faisceau de projection, et la durée pendant laquelle le faisceau mis en forme est projeté sur ladite partie.

**8.** Appareil selon l'une quelconque des revendications précédentes, dans lequel lesdits moyens de prédiction (11) prédisent ladite perte d'intensité en fonction d'une position sur ledit masque et lesdits moyens de compensation (13) effectuent une compensation sur la dose d'exposition délivrée sur le substrat également en fonction de la position.

**9.** Appareil selon l'une quelconque des revendications précédentes, dans lequel ladite prédiction est calculée sur la base de données obtenues de manière empirique concernant la distribution temporelle et spatiale d'une contamination dans ledit appareil ou dans un appareil analogue.

**10.** Appareil selon la revendication 9, dans lequel lesdits moyens de mise en forme sont un masque (MA) et lesdites données obtenues de manière empirique incluent des données concernant une contamination dans un appareil de manipulation de masque associé (ML) et l'opération d'un ou plusieurs dispositifs de nettoyage de masque associés (CS).

**11.** Appareil selon l'une quelconque des revendications précédentes, dans lequel lesdits moyens de prédiction (11) prédisent la perte d'intensité non voulue due à des effets induits par irradiation dans les moyens de mise en forme à la place ou en plus de la perte provoquée par la contamination de surface.

**12.** Procédé de fabrication de dispositif comprenant les étapes consistant à :

- fournir un substrat qui est au moins partiellement recouvert d'une couche de matériau sensible au rayonnement ;
- délivrer un faisceau de projection de rayonnement en utilisant un système de rayonnement ;
- utiliser des moyens de mise en forme pour doter le faisceau de projection d'un motif dans sa section transversale correspondant à un motif voulu à créer dans un substrat, les moyens de mise en forme comportant un masque ou un réseau de miroirs programmables ;
- projeter le faisceau de rayonnement mis en forme sur une partie cible de la couche du matériau sensible au rayonnement,

**caractérisé par** les étapes supplémentaires consistant à :

prédire, sur la base de l'historique desdits moyens de mise en forme, la perte d'intensité non voulue dans le faisceau mis en forme due à une contamination de surface desdits moyens de mise en forme ; et

compenser la perte d'intensité prédite.

**13.** Programme informatique pour faire fonctionner un appareil de projection lithographique utilisant des moyens de mise en forme pour doter un faisceau de projection d'un motif dans sa section transversale correspondant à un motif voulu à créer dans un substrat, les moyens de mise en forme comportant un masque ou un réseau de miroirs programmables, ledit programme informatique comportant des moyens de code pour ordonner à un appareil de projection lithographique utilisant les moyens de mise en forme de :

prédire, sur la base de l'historique desdits moyens de mise en forme, la perte d'intensité non voulue dans le faisceau mis en forme due à une contamination de surface desdits moyens de mise en forme, et

commander ledit appareil de projection lithographique pour compenser la perte d'intensité prédite.

Fig. 1

# Fig. 2

10

# Fig. 3

Fig. 4

ref. pos.: 100 pulses/point
irr. pos.: 500 pulses/point
$mJ/cm^2$

50 Hz, $O_2 < 0.5$ ppm